Europäisches Patentamt

European Patent Office

Office européen des brevets

(19)

(11) Publication number: 0 204 498
A2

(12) **EUROPEAN PATENT APPLICATION**

(21) Application number: 86304038.2

(22) Date of filing: 28.05.86

(51) Int. Cl.⁴: H 01 L 29/60
G 11 C 17/00

(30) Priority: 29.05.85 US 738919

(43) Date of publication of application:
10.12.86 Bulletin 86/50

(84) Designated Contracting States:
AT BE CH DE FR GB IT LI LU NL SE

(71) Applicant: ADVANCED MICRO DEVICES, INC.
901 Thompson Place P.O. Box 3453
Sunnyvale, CA 94088(US)

(72) Inventor: Liu, Yow-Juang Bill
350 St. Julie Drive
San Jose California(US)

(72) Inventor: Radjy, Nadar Ali
1760 Pacific Street No. 4
San Francisco California(US)

(72) Inventor: Cagnina, Salvatore F.
1537 Arbor Avenue
Los Altos California(US)

(74) Representative: Wright, Hugh Ronald et al,
Brookes & Martin 52/54 High Holborn
London WC1V 6SE(GB)

(54) Improved eeprom cell and method of fabrication.

(57) An integrated circuit EEPROM cell having a reduced aspect ratio and the method of fabrication is disclosed. The layout and method of fabrication results in a self-aligned EPROM channel, an improved coupling ratio, and a reduction in required substrate area. The cell is slightly widened and the connection junction and tunneling junction are restructured in order to shrink the length of the cell and achieve the reduced aspect ratio.

EP 0 204 498 A2

IMPROVED EEPROM CELL AND METHOD OF FABRICATION

The present invention generally relates to integrated circuit memory devices and, in particular, to improved electrically erasable programmable read only memory (EEPROM) cells and their method of fabrication.

During the evolution of memory-type integrated circuits, a need for reprogrammable cells became apparent. One of the integrated circuit devices which has come to fill this need is the EEPROM cell.

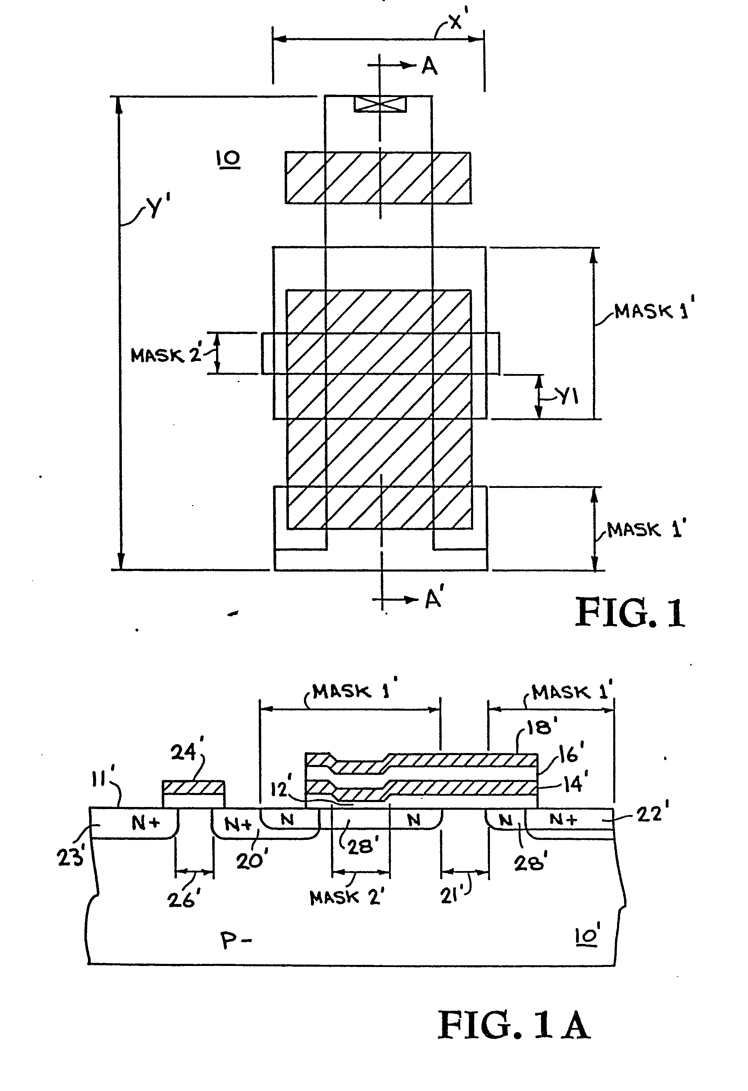

One type of EEPROM cell is commonly known as the "tunneling" EEPROM: a simplified cross-sectional diagram of such a memory device is shown in Figure 1a (taken along section A-A' of Figure 1). The device is built in and on a doped substrate 10'. Basically, an EEPROM has a floating gate field effect transistor (FET), which is the EPROM section of the cell used to store a data bit, and an adjacent select FET. The "tunneling" FET "memory" can be accessed for reading such a stored bit by coupling its drain region 20' to a contact region 23' (which is also the drain region of the select FET. By placing a charge on select gate 24', the space-charge layer channel 26' of the select FET begins conducting, thereby coupling the drain 20' to the contact 23'.

This type of EEPROM makes use of reversible electron tunneling through a thin oxide layer 12' of the tunneling FET to allow a charge, representing a bit of digital information to be stored and erased from the floating gate 14'. The electron tunneling is controlled using capacitive coupling of the control gate 18' with the floating gate 14' to both program and erase the floating gate. It is advantageous to improve the coupling ratio (that is, the intergate capacitance/tunnel oxide capacitance) such that a smaller voltage is required to induce the electron tunneling mechanism.

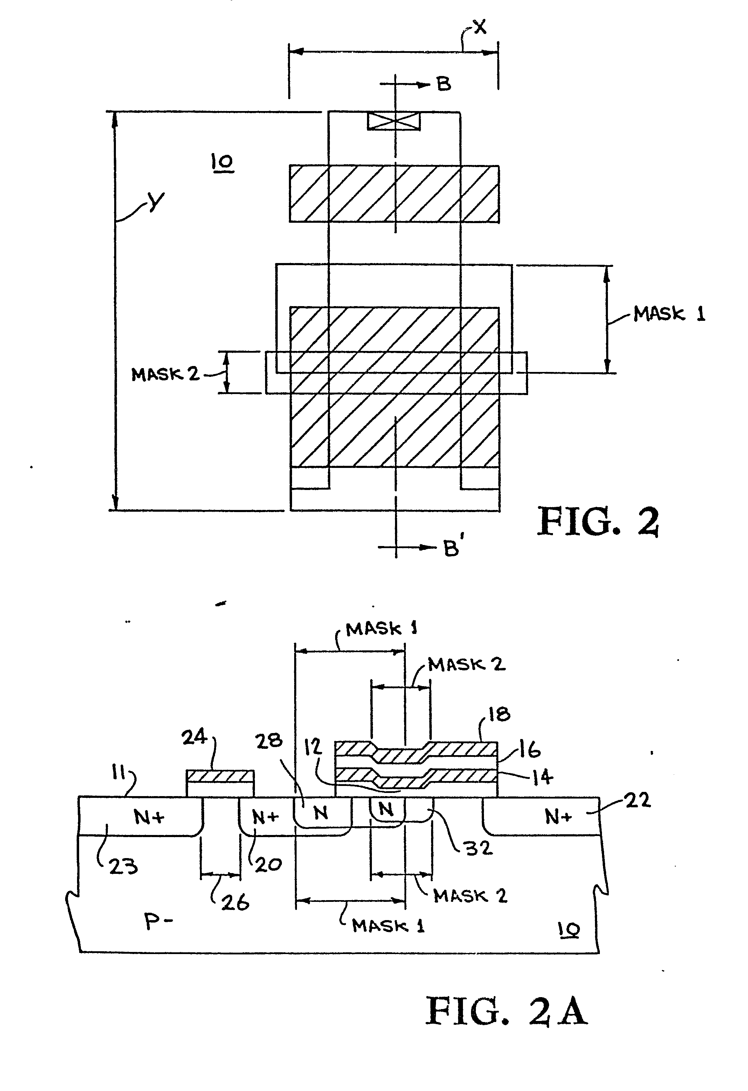

One drawback of the EEPROM cell is that this structure is a relatively large integrated circuit component. The connection junction regions 28' connect the select transistor to the cell tunneling areas. These regions in the prior art structure define not only the connection junction regions, but also the EPROM FET channel 21' and the tunneling window (designated Mask 2') beneath the tunnel oxide 12'. Alignment during fabrication is a critical step. Mask 1' represents the position and length dimension of connection junction regions, and Mask 2' represents the tunneling                                    window . In a typical array, each two cells share a contact 23, 23'; i.e., in Figures 1 and 2 an adjacent mirror image of each shown cell would exist. In the prior art, the total length of the connection junction regions per cell is relatively large (with the actual length depending upon the design rules).

As shown in Figure 1, a typical cell of the current art has a width, or x' dimension, and a length, or y' dimension, which results in a relatively large surface area aspect ratio, y'/x'. Therefore, an array of such cells and their complements on a single integrated circuit die is severely limited in number.

Hence, there is a need to shrink the EEPROM cell size without losing any effectiveness and, preferably, while improving operational characteristics.

We will describe
an improved EEPROM cell, having reduced device geometries with a decreased aspect ratio.

We will also describe
a method of fabricating an EEPROM cell having a tunnel junction region and channel region of the tunneling memory, FET self-aligned.

We will also describe
an improved EEPROM cell having a layout structure adaptable to further shrinkage with improvement in the state-of-the-art lithography techniques.

We will also describe
a method of fabricating a smaller EEPROM cell while reducing device defects, thus providing a high manufacturing yield.

We will further describe an EEPROM cell having an improved coupling ratio .

The present invention provides an improved integrated circuit EEPROM cell of a length y and a width x, defining a surface area aspect ratio y/x, having a tunneling transistor coupled to an adjacent select transistor, characterized by:
a single substrate region for coupling said tunneling transistor to said select transistor, and
a tunneling region of said tunneling transistor at least partially inset in said connection junction region,

such that the overall length of said cell and said aspect ratio of said cell are reduced.


Other objects, features and advantages of the present invention will become apparent upon consideration of the following detailed description and the accompanying drawings, in which like reference designations represent like features throughout the Figures.


## BRIEF DESCRIPTION OF THE DRAWINGS

Figure 1 is a schematic plan view (top) of a prior art EEPROM cell showing approximate dimensions:

Figure 1a is a schematic cross-sectional view taken in plane A-A' of the EEPROM cell of Figure 1;

Figure 2 is a schematic plan view (top) of the EEPROM cell in accordance with the present invention showing approximate dimensions;

Figure 2a is a schematic cross-sectional view taken in plane B-B' of the EEPROM cell of Figure 2;

Figures 3-7 are cross-sectional drawings showing an idealized process sequence for the method of manufacture of the EEPROM cell according to the present invention, in which:

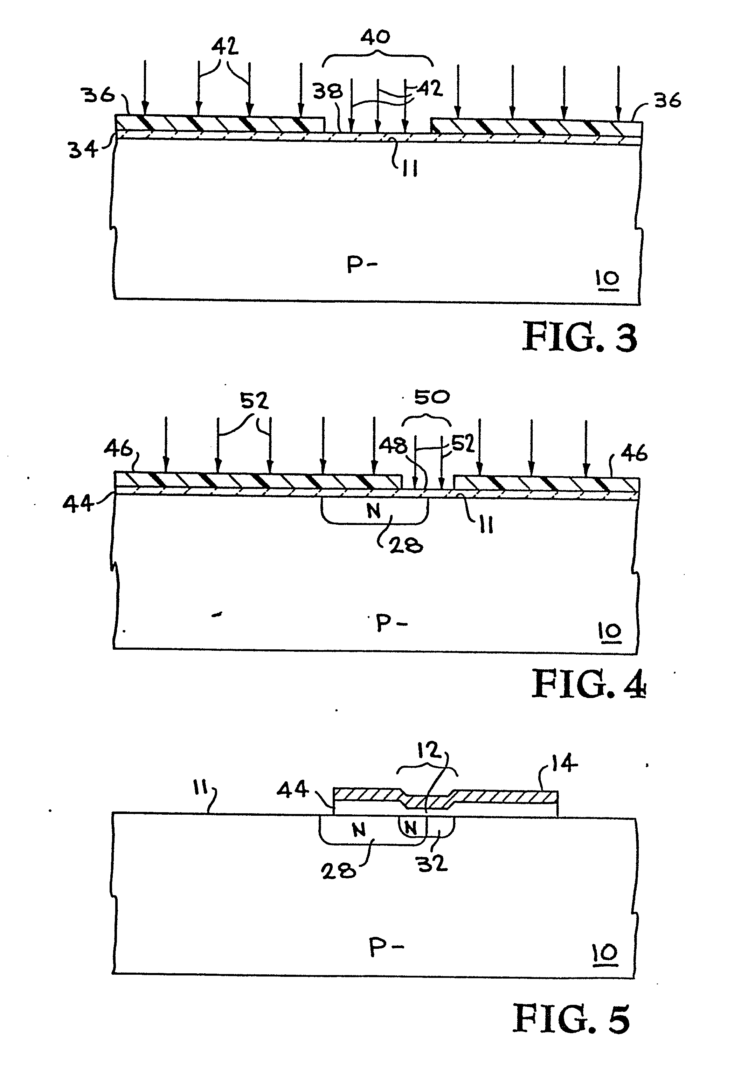

Figure 3 shows the formation of the connection junction between the select transistor and the EEPROM tunneling areas;

Figure 4 shows the formation of the tunneling junction and the tunneling area;

Figure 5 shows step completion of the formation of the EEPROM tunnel oxide layer and superposing floating gate;

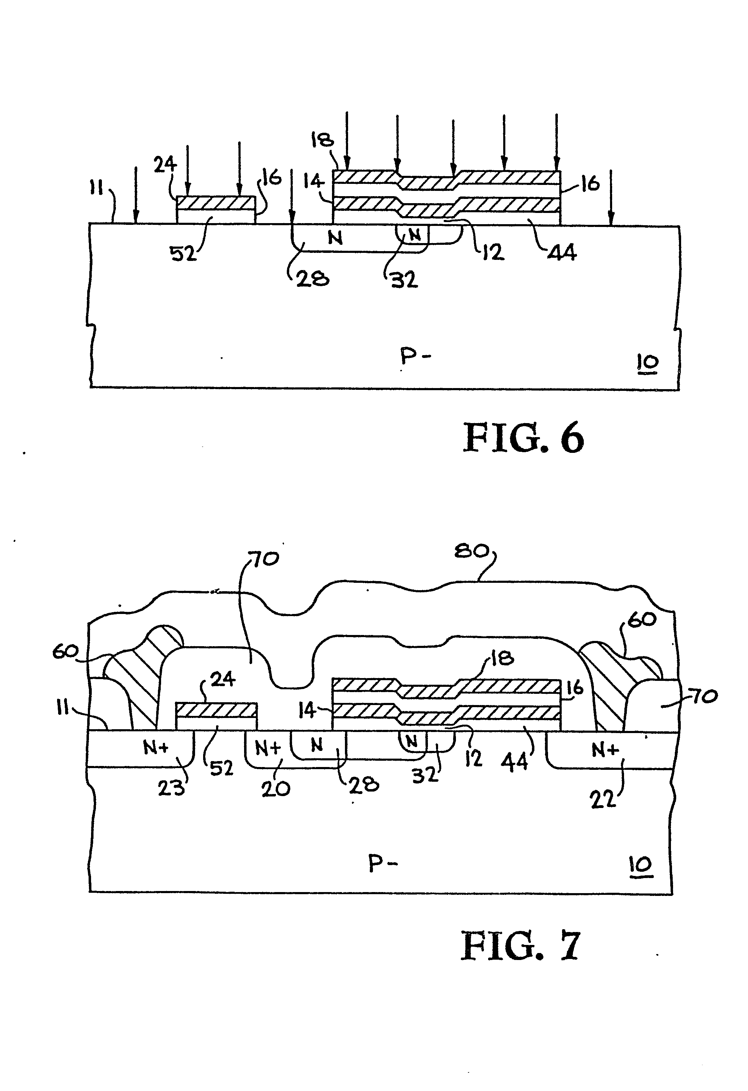

Figure 6 shows step completion of the formation of the select gate and control gate and the formation of the source and drain regions for the transistors; and

Figure 7 shows the completed EEPROM cell in accordance with the present invention.

## DETAILED DESCRIPTION OF THE INVENTION

Reference is now made in detail to a specific embodiment of the present invention, which illustrates the best mode presently contemplated by the inventors for practicing the invention. Alternative embodiments are also briefly described. The drawings referred to in this description should be understood not to be drawn to scale except where specifically noted. Moreover, the drawings are intended to illustrate only one portion of an integrated circuit fabricated in accordance with the present invention.

The present invention is an EEPROM cell as generally shown in Figures 2 and 7. There is a substrate 10 of a first conductivity type having an upper surface 11. A tunneling FET source region 22 of a second conductivity type is embedded in a first area of said surface 11 of said substrate 10. A tunneling FET drain region 20 of said second conductivity type is embedded in a second area of said substrate surface 11 , spaced from said first area. A tunneling FET channel region in a third area of said substrate lies between the first and second areas. A floating gate 14 superposes the tunneling FET channel region. An interstitial tunnel layer 12 is located between a lower surface of the floating gate 14 and said tunneling FET channel region. A control gate 18 superposes the floating gate 14.

A select gate 24 is adjacently spaced from the floating gate 14, superposing the substrate surface 11 adjacent the tunneling FET drain region 20. A select transistor drain region 23 is located in a fourth area of the substrate surface 11, adjacently spaced from the tunneling FET drain region 20 and distally from said tunneling FET channel region. A select transistor channel region 26 is formed at said surface 11 of said substrate 10 below the select gate 24 with the tunneling FET drain region 20 also acting as the select FET source region.

A connection junction region 28 of the second conductivity type lies embedded in the substrate surface 11, underlying a portion of said space between the select gate 24 and the floating gate 14 and under a portion of the tunnel dielectric layer 12. A tunnel junction region 32 of said second conductivity type is embedded in the third area of the substrate 10 underlying the tunnel dielectric layer 12. In order to shrink the overall size of the cell, the length (y) of the cell is decreased by having the tunnel junction region 32 and the connection region 20 overlap, as indicated by references Mask 1 and Mask 2 in Figures 2 and 2a. To optimize the cell performance, the aspect ratio can be reduced by also increasing the width (x) of the cell, while maintaining the overall reduction in cell area.

Referring to Figure 3, the basic process starts with a silicon wafer which defines an integrated circuit substrate 10. Such wafers are commercially available. The substrate is doped lightly to have a first conductivity type, in this exemplary embodiment, p-type. The details of common techniques as are used in the fabrication process for p-type or n-type versions of the present invention are well known in the art. Many classical texts publish such details: see, e.g., Semiconductor & Integrated Circuit Fabrication Techniques, Reston Publishing Company, Inc., copyright 1979, by the Fairchild Corporation. Moreover, the individual steps can be performed using commercially available integrated circuit fabrication machines.

A pre-connection implant barrier, or "pad," layer 34 is formed on the top surface 11 of the substrate 10. Typically, a thin layer of silicon dioxide of approximately 50 to 300 Angstroms in thickness is grown on the substrate surface 11 to form this pre-connection implant layer 34. This layer 34 is used to protect what is, or will become, active device regions in the substrate 10 during the connection junction implant step of the fabrication.

Next, a mask 36 of photoresist is formed on the surface 38 of the layer 34, having an aperture 40 where the connection region´implant is to be made in the substrate 10. Ions, represented by arrows 42, which will render the substrate 10 to have a region of a second conductivity type, viz., n-type, are introduced into the mask-defined areas of the substrate 10 below the aperture 40 to become the connection junction between the yet-to-be-formed select FET and tunneling FET. Generally, an ion implantation, such as arsenic in an n-channel MOS process, can be used for this step. The exact dosage will be determined by the desired thickness of the gate dielectric layer 44 yet to be formed; the dose should be sufficient to avoid surface depletion in the connection region during all stages of cell operation. At the completion of the ion bombardment, the area below the surface 11 of the substrate 10 not protected by the mask 36 has become doped to form an n-type conductivity connection junction 28 as demonstrated in Figure 4.

The mask 36 is then removed. A floating gate dielectric layer 44 is formed on the surface 11 of the substrate 10. This is generally a silicon dioxide layer grown thermally to a thickness having a range of approximately 100 to 500 Angstroms. Another mask 46 of photoresist is formed on the surface 48 of the gate dielectric layer 44. This mask 46 has an aperture 50 where the tunneling junction region in the substrate 10 is to be formed. Another ion bombardment, represented by the arrows labelled 52, is performed. Again, ions such as arsenic, which will render the substrate to have another n-type region, are implanted. This doping dosage is approximately to the same order as the previous connection junction implant. At the completion of this implant, the area below the substrate surface 11 not protected by the mask 46 has become doped to form an n-type conductivity tunneling junction 32 as shown in Figure 5.

It is important to note a comparison to the prior art structure as best seen between Figures 1 and 2 and 1a and 2a, respectively. As can be seen in Figures 1 and 1a, the connection junction regions 28' of the prior art are n-type regions in the substrate 10' labelled as Mask 1'; the tunneling junction region 21 is that part of the n-type region in the substrate 10' labelled as Mask 2'. As demonstrated in Figures 1 and 2, the spacing y1 is eliminated in the present invention. This results in a smaller y dimension, which is equal to y'-y1. This is a significant reduction stemming from the novel overlapping layout of the connection junction region 28 with the tunneling junction region 32 as shown in Figures 2a and 5.

Referring again to Figure 5, the gate dielectric layer 44 is etched to clear the substrate surface 11 in aperture 50, i.e., over the tunnel junction implanted area 32. The photoresist layer 46 is then stripped. A thin-film tunneling layer 12 is formed over the tunnel junction area 32.

Note carefully, that the thin tunneling dielectric layer 12 has been self-aligned to the tunneling junction area 32 and to the yet-to-be-formed superposing floating gate.

The floating gate 14 is formed having this self-alignment by forming a layer of highly conductive material, typically n-type doped polycrystalline silicon; for example, a thickness of approximately 1000 to 7000 Angstroms can be used according to the current state of the art. Conventional thin film, photomasking, and etching techniques are then used to define the geometry of the floating gate 14 to cover both the tunneling layer 12 and the adjacent floating gate dielectric layer 44. Through conventional thermal oxidation or thin film techniques, an interpoly-silicon layer 16 is formed on top of the floating gate 14 and substrate surface 11. The select gate dielectric 52 also is formed on substrate surface 11 by this step. The composition of this layer can be silicon dioxide, silicon nitride, or a multilayer combination of these materials.

A shallow p-type ion implantation, typically boron ions, is then performed into the substrate 10 to adjust the doping concentration near its surface 11, such that an enhancement-type select transistor may be formed.

Next, a second layer of highly conductive material, such as n-type doped polycrystalline silicon, is formed (in the current state of the art, to a thickness of approximately 1000 to 7000 Angstroms) and patterned to form the select gate 24 and the control gate 18 as shown in Figure 6.

Following the formation of these gates 24, 18, an n-type (such as arsenic ions) implantation, illustrated by unnumbered arrows in Figure 6, is used to form the source 22 and drain 20 of the tunneling FET and the drain 23 of the select FET, as shown in Figure 7. Note that the drain 20 of the tunneling FET acts as the source of the select FET. These formations also self-align the channel 21 of the tunneling FET.

The choice of doing self-aligned control gate formation and the use of source/drain implant mask formation are dependent upon various optional techniques and may also be a function of the type of process being used, e.g., NMOS or CMOS. Details of these options are well known to those skilled in the art.

After the source and drain junctions have been formed, conventional finishing steps of metallization, insulation, and passivation layers are performed, as shown in Figure 7 at completion and labelled 60, 70 and 80, respectively.

From a comparison of Figures 1 and 2, it can be seen that the relative aspect ratio, y/x, of the EEPROM cell has been reduced significantly over y'/x'. Not only does this result in a substantial savings in substrate area necessary to build the cell, but the device of the present invention is easier to manufacture (higher yield) using current fabrication techniques. As shown in Figure 2, there is a greater dimension flexibility, allowing for alignment offsets. This provides a cell with a greater potential for shrinkage since the formation is directly tied to stepper machine rules for alignment: that is, as the stepper rules improve, the cell can be made even smaller.

Moreover, it has been discovered that the drain coupling ratio of the present invention is reduced over the prior art. As a result, the electrical characteristics of the cell become less sensitive to process variations. This further eases manufacturing and improves yield.

The foregoing description of the preferred embodiment of the present invention has been presented for purposes of illustration and description. It is not intended to be exhaustive or to limit the invention to the precise form disclosed. Obviously, many modifications and variations will be apparent to practitioners skilled in the art. It is possible that the invention may be practiced in other technologies, such as with bipolar or other MOS processes. Similarly, the process steps described may be performed in a different order to achieve the same result. The embodiment was chosen and described in order to best explain the principles of the invention and its practical application, to thereby enable others skilled in the art to best understand the invention for various embodiments and with various modifications as are suited to the particular use contemplated. It is intended that the scope of the invention be defined by the claims appended hereto and their equivalents.

## CLAIMS

1. An improved integrated circuit EEPROM cell of a length y and a width x, defining a surface area aspect ratio y/x, having a tunneling transistor coupled to an adjacent select transistor, characterized by:

a single substrate region for coupling said tunneling transistor to said select transistor, and

a tunneling region of said tunneling transistor at least partially inset in said connection junction region,

such that the overall length of said cell and said aspect ratio of said cell are reduced.

2. The improved EEPROM cell as set forth in claim 1, wherein y = y'-yl as defined herein.

3. The improved EEPROM cell as set forth in claim 2, wherein said width x of said cell is increased such that said aspect ratio is further reduced for the same or lesser surface area.

4. An electrically erasable programmable read only memory (EEPROM) cell, comprising:

a substrate of a first conductivity type having an upper surface;

a FET source of a second conductivity type embedded in a first region of said surface of said substrate;

a FET drain of said second conductivity type embedded in a second region of said substrate surface spaced from said first region;

a FET channel in a third region of said substrate lying between said first and second regions;

a floating gate superposing said channel and overlapping said first and second regions;

a tunnel dielectric layer between at least a portion of said floating gate and said FET channel;

a control gate superposing said floating gate;

a select gate, adjacently spaced from said floating gate, superposing said substrate adjacent said FET drain;

a select transistor drain in a fourth region of said substrate adjacently spaced from said FET drain, distally from said FET channel, such that a select transistor channel is formed in said substrate below said select gate and said FET drain acts as the select transistor source.

a connection junction region of said second conductivity type embedded in said surface of said substrate underlying a portion of said space between said select gate and said floating gate and a portion of said tunnel dielectric layer; and

a tunnel junction region of said second conductivity type embedded in said third region of said substrate underlying said tunnel dielectric layer,

whereby said tunnel junction region and said connection region overlap.

5.    The EEPROM cell as set forth in claim 4, further comprising:

an interstitial dielectric layer between said control gate and said floating gate.

6.    The EEPROM cell as set forth in claim 5, further comprising:

an interstitial dielectric insulator layer between said select gate and said substrate surface.

7.    A method of fabricating an integrated circuit EEPROM cell of a length y and a width x, defining a surface area aspect ratio y/x, having a tunneling transistor and an adjacent select transistor, comprising:

forming a region to couple said tunneling transistor to said select transistor, and

forming a tunneling junction region of said tunneling transistor such that said connection junction region and said tunneling junction region at least partially overlap,

such that said EEPROM cell has a low surface area aspect ratio.

8.    The method as set forth in claim 7, wherein said length y = y'-yl as defined herein.

9.     A method of fabricating an integrated circuit EEPROM cell in a substrate of a first conductivity type having a generally planar upper surface, comprising the steps of:

forming a FET source of a second conductivity type in a first region of said surface of said substrate;

forming a FET drain of said second conductivity type in a second region of said substrate surface spaced from said first region, such that

a FET channel is formed in a third region of said substrate lying between said first and second regions;

forming a floating gate superposing said FET channel and overlapping said first and second regions;

forming an interstitial tunnel dielectric layer between at least a portion of a lower surface of said floating gate and said FET channel;

forming a control gate superposing said floating gate;

forming a select gate, adjacently spaced from said floating gate, superposing said substrate adjacent said FET drain;

forming a select transistor drain in a fourth region of said substrate adjacently spaced from said FET drain, distally from said FET channel, such that a select transistor channel is formed in said substrate below said select gate and said FET drain acts as the select transistor source;

forming a connection junction region of said second conductivity type embedded in said surface of said substrate underlying a portion of said space between said select gate and said floating gate and a portion of said tunnel dielectric layer; and

forming a tunnel junction region of said second conductivity type embedded in said third region of said substrate underlying said tunnel dielectric layer,

whereby said tunnel junction region and said connection region overlap.

10. The method as set forth in claim 9, further comprising the steps of:

forming an interstitial insulator layer between said control gate and said floating gate.

11. The method as set forth in claim 10, further comprising the steps of:

forming an interstital insulator layer between said select gate and said substrate surface.

12. The method as set forth in claim 11, wherein said insulator layers are formed of silicon dioxide.

1/4

FIG. 1

FIG. 1 A

FIG. 2

FIG. 2A

**FIG. 3**

**FIG. 4**

**FIG. 5**

**FIG. 6**

**FIG. 7**